# EUROPÄISCHE PATENTSCHRIFT

(11) **EP 2 848 448 B1**
(45) Veröffentlichungstag und Bekanntmachung des Hinweises auf die Patenterteilung: **03.10.2018**
(21) Anmeldenummer: 14001059.6
(22) Anmeldetag: 21.03.2014
(51) Int. Cl.: B60K 35/00, B60L 11/18, B60Q 1/26, G01R 31/36, H02J 7/00, B60Q 1/00, B60L 3/00, B60L 3/12, B60Q 1/50, B60L 11/00

(54) **Fahrzeug mit Elektroantrieb und einer Anzeigevorrichtung zur Anzeige eines Betriebszustandes eines Energiespeichers des Elektroantriebs**
Vehicle having an electric drive and a display device for indicating the operating condition of an energy store of the electric drive
Véhicule doté d'un entraînement électrique et d'un dispositif d'affichage pour l'affichage d'un état de fonctionnement d'un accumulateur d'énergie de l'entraînement électrique

(30) Priorität: 24.08.2013 DE 102013014104
(43) Veröffentlichungstag der Anmeldung: 18.03.2015
(73) Patentinhaber: MAN Truck & Bus AG, 80995 München (DE)
(72) Erfinder: Grimm, Thomas, 80339 München (DE)
(74) Vertreter: v. Bezold & Partner Patentanwälte - PartG mbB

(56) Entgegenhaltungen:
- WO-A2-2013/087670
- FR-A1- 2 980 646
- JP-A- 2011 182 563
- JP-A- 2013 086 552
- US-A1- 2010 238 006

## Beschreibung

Die Erfindung betrifft ein Fahrzeug, nämlich einen Omnibus, mit einem Elektroantrieb und einer Anzeigevorrichtung zur Anzeige eines Betriebszustandes, insbesondere eines Ladezustands, eines Energiespeichers des Elektroantriebs.

Kraftfahrzeuge mit Elektroantrieb, beispielsweise Elektrokraftfahrzeuge oder Hybridelektrokraftfahrzeuge, bei denen ein oder mehrere Räder von einem Elektromotor angetrieben werden, sind aus dem Stand der Technik bekannt. Zunehmend werden auch Omnibusse, beispielsweise Stadtbusse, mit Elektroantrieben ausgestattet. Aus dem Stand der Technik ist ferner bekannt, dass derartige Fahrzeuge eine Anzeigevorrichtung umfassen, die den Betriebszustand, insbesondere den Ladezustand eines Energiespeichers des Elektroantriebs anzeigt. Derartige Anzeigevorrichtungen sind jedoch im Fahrzeugcockpit angeordnet, so dass diese nur für den Fahrer sichtbar ist.

Einem Kraftfahrzeug ist es in der Regel jedoch nicht unmittelbar anzusehen, ob dieses einen Elektroantrieb aufweist oder nur mit einem konventionellen Antrieb ausgestattet ist. Es wäre jedoch wünschenswert, beispielsweise für umweltbewusste Busfahrgäste, wenn ein Fahrzeug einfach als ein Fahrzeug mit Elektroantrieb identifizierbar wäre.

Bei Fahrzeugen, die von außen geladen werden kann es vorkommen, dass es beim Ladeprozess zu Störungen kommt, die das Laden des Fahrzeugs verhindern, ohne dass dies von außen bemerkt wird. Gegenmaßnahmen können nicht ergriffen werden. Das Fahrzeug kann zum vorgesehenen Anfahrzeitpunkt nicht genutzt werden.

Bei Unfallsituationen ist es dem Rettungspersonal nicht sofort ersichtlich, ob das Fahrzeug mit Hochvoltenergiespeichern ausgestattet ist und in welchem Zustand die Energiespeicher sich befinden. Dies ist allerdings für die Sicherheit des Rettungspersonals entscheidend, das sich auf die Situation einstellen können und andere Rettungsmaßnahmen als bei reinen Verbrennungskraftmaschinenfahrzeugen ergreifen können.

In der Offenlegungsschrift WO 2013/087670 A2 ist bekannt, eine Information über einen Energiespeicher eines Fahrzeugs mit Leuchtmitteln des Fahrzeugs darzustellen, die auch eine Lichtfunktion des Fahrzeugs realisieren. Auch in der FR 2 980 646 A1 wird vorgeschlagen, die Außenbeleuchtungseinrichtung des Fahrzeugs zu nutzen, um eine Anzeige des Betriebszustandes bereitzustellen, die von außerhalb des Fahrzeug sichtbar ist. In den Offenlegungsschriften JP 2013 086552 A und JP 2011 182563 A wird jeweils vorgeschlagen, eine Anzeigevorrichtung betreffend den Batterieladezustand mittig oben auf einem Fahrzeugdach anzuordnen. In der Offenlegungsschrift US 2010/238006 A1 wird zur Kennzeichnung eines Ladezustandes eines elektrischen Energiespeichers vorgeschlagen, eine Anzeige an einem vorderen Kotflügel oder an einer A-Säule oder B-Säule des Fahrzeugs anzuordnen.

Eine Aufgabe der Erfindung ist es, ein Kraftfahrzeug mit einem Elektroantrieb bereitzustellen, das Nachteile herkömmlicher derartiger Fahrzeuge vermeidet. Eine Aufgabe der Erfindung ist es insbesondere, ein Kraftfahrzeug bereitzustellen, das leicht als Fahrzeug mit Elektroantrieb zu erkennen ist und dessen Betriebszustand der Energiespeicher einfach erkennbar ist. Diese Aufgaben werden durch ein Fahrzeug mit den Merkmalen des Hauptanspruchs gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Das erfindungsgemäße Fahrzeug weist in Übereinstimmung mit dem Stand der Technik einen Elektroantrieb auf. Das Fahrzeug kann ein reines Elektrokraftfahrzeug oder ein Hybridelektrokraftfahrzeug mit und ohne elektrischem Aufladen von außen sein. Erfindungsgemäß ist das Fahrzeug ein Omnibus, beispielsweise ein Stadtbus.

Das Fahrzeug umfasst eine Anzeigevorrichtung zur Anzeige eines Betriebszustandes eines Energiespeichers des Elektroantriebs, insbesondere zur Anzeige eines Ladezustands. Der Energiespeicher kann z.B. eine Batterie oder eine Anordnung von Ultrakondensatoren sein. Gemäß allgemeinen Gesichtspunkten der Erfindung ist die Anzeigevorrichtung an der Fahrzeugaußenhaut angeordnet, derart, dass die Anzeige des Betriebszustandes von außerhalb des Fahrzeugs sichtbar ist.

Das erfindungsgemäße Vorsehen der Anzeigevorrichtung an der Fahrzeugaußenhaut anstatt im Fahrzeugcockpit hat den Vorteil, dass beispielsweise für einen Fahrgast noch vor Betreten des Omnibusses erkennbar ist, ob das Fahrzeug mit einem Elektroantrieb ausgestattet ist. Der außenseitig angezeigte Betriebszustand bietet im Vergleich zu einem einfachen Schriftzug zur Kenntlichmachung als Elektro- oder Hybridfahrzeug weiter den Vorteil, dass auch von außen der Betriebszustand des Energiespeichers, beispielsweise der Ladezustand, erkennbar ist. Dadurch kann beispielsweise ein Fahrer den Fortschritt des Ladevorgangs des Energiespeichers von einem nahegelegenen Ort, z. B. einem Büro oder Cafe, überprüfen, ohne das Fahrzeug betreten zu müssen.

Bei dem erfindungsgemäßen Omnibus ist die Anzeigevorrichtung an einem oberen seitlichen Dachabschnitt angeordnet

Ein besonderer Vorzug der Erfindung liegt darin, dass die Anzeigevorrichtung eingerichtet sein kann, anzuzeigen, wenn der Energiespeicher von einer externen Energiequelle aufgeladen wird. Die Erfinder haben festgestellt, dass es beim Anschließen einer externen Stromversorgung zum Aufladen des Energiespeichers des Elektroantriebs oftmals zu Fehlfunktionen kommt, wenn der Ladestecker nicht richtig in die Steckerbuchse eingesteckt wird oder wenn die externe Stromversorgung keinen Strom liefert. Durch das erfindungsgemäße Anzeigen, ob der Energiespeicher extern geladen wird, kann der Fahrer von außerhalb des Fahrzeugs überprüfen, ob ein externer Ladevorgang stattfindet und so ein zeitaufwändiges Wiedereinsteigen in das Fahrzeug und ein Einschalten des Fahrzeugs nach Anbringen des Ladesteckers vermieden werden.

Die erfindungsgemäße Realisierung sieht vor, dass die Anzeigevorrichtung eine Vielzahl von Anzeigeelemente umfasst, die linear ausgerichtet angeordnet sind.

Vorzugsweise nimmt die Anzahl der erleuchteten Anzeigeelemente mit abnehmenden Ladezustand des Energiespeichers ab und mit zunehmenden Ladezustand des Energiespeichers zu. Auf diese Weise kann ein vollständig geladener Energiespeicher durch gleichzeitiges Erleuchten aller Anzeigeelemente dargestellt werden, und ein Teilladezustand durch Erleuchten nur eines Teils der Anzeigeelemente, wobei die Anzahl der erleuchteten Anzeigeelemente proportional zum Ladezustand des Energiespeichers ist.

Die Anzeigeelemente sind als LED Punktmatrizen oder OLED ausgebildet, die ein gut sichtbares, robustes und energieeffizientes Leuchtmittel darstellen. Mittels der LED Punkt matrizen können die einzelnen Anzeigeelemente als farbig erleuchtbare Punktflächen realisiert werden.

Die Anzeigevorrichtung ist so dimensioniert, dass die Anzeige des Betriebszustands des Energiespeichers aus mehreren Metern Entfernung zum Fahrzeug, beispielsweise aus mindestens 5 Metern oder mindestens 10 Metern erkennbar ist. Hierbei haben die einzelnen Anzeigeelemente eine Durchmesser von mindestens 10 cm.

Eine bevorzugte Ausführungsform sieht vor, dass die Anzeigevorrichtung eingerichtet ist, einen Ladezustand des Energiespeichers auch im Nichtfahrbetrieb des Fahrzeugs anzuzeigen. Dies bedeutet, dass der Betriebszustand auch bei einem geparkten, ausgeschalteten Fahrzeug angezeigt wird. Dadurch kann der Ladezustand des Energiespeichers eines geparkten Fahrzeugs von außen überwacht werden.

Bei einem Omnibus sieht eine weitere erfindungsgemäße Variante vor, dass der Omnibus eine zweite Anzeigevorrichtung zur Anzeige des Betriebszustandes des Energiespeichers des Elektroantriebs umfasst, die im Fahrzeuginneren angeordnet ist, derart, dass der von der zweiten Anzeigevorrichtung angezeigte Betriebszustand für auf Fahrgastsitzen sitzende Fahrgäste sichtbar ist. Der Omnibus umfasst ferner eine dritte, aus dem Stand der Technik bekannte Anzeigevorrichtung zur Anzeige des Betriebszustandes des Energiespeichers des Elektroantriebs, die im Cockpit angeordnet ist.

Weitere Einzelheiten und Vorteile der Erfindung werden im Folgenden unter Bezug auf die beigefügten Zeichnungen beschrieben. Es zeigen:
- FIG. 1: eine schematische Seitenansicht eines Fahrzeugs gemäß einem Ausführungsbeispiel; und
- FIG. 2A bis 2D: verschiedene Anzeigezustände der Anzeigevorrichtung gemäß einem Ausführungsbeispiel.

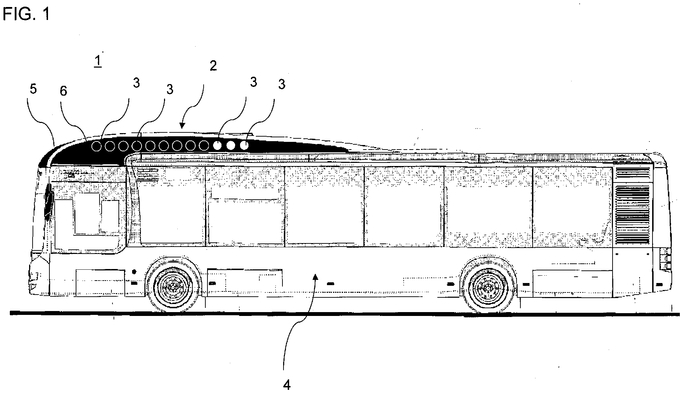

Fig. 1 zeigt eine schematische Seitenansicht eines Omnibusses 1. Der Omnibus 1 verfügt über einen Elektroantrieb und eine Batterie für den Elektroantrieb (nicht gezeigt), die an sich aus dem Stand der Technik bekannt sind und hier nicht weiter beschrieben sind. Die Fahrzeugkarosserie umfasst einen vorderer Dachaufbau 5, der zur Verbesserung der Aerodynamik in Längsrichtung des Omnibusses 1 abflacht. An beiden gegenüberliegenden Seitenflächen 4 des Omnibusses 1 ist außenseitig eine Anzeigevorrichtung 2 befestigt, wovon in Figur 1 nur eine der beiden Anzeigevorrichtungen 2 sichtbar ist. Die Anzeigevorrichtung 2 ist insbesondere an einem seitlichen Abschnitt 6 des Dachaufbaus 5 angeordnet, so dass diese Anzeigevorrichtung 2 gut sichtbar ist und nicht von vorbeifahrenden Fahrzeugen oder von Personen, die sich vor der Seitenfläche 4 des Omnibusses 1 aufhalten, verdeckt werden. Die Anzeigevorrichtung 2 umfasst zwölf linear angeordnete Leuchtelemente 3, die hier als farbig leuchtende Punkt-Matrizen ausgeführt sind. Die Abstrahlrichtung der Punkt-Matrizen ist nach außen, d. h. vom Omnibus 1 weg, so dass das von den Leuchtelementen 3 emittierte Licht von Personen, die sich seitlich vom Bus 1 befinden, gut gesehen werden kann.

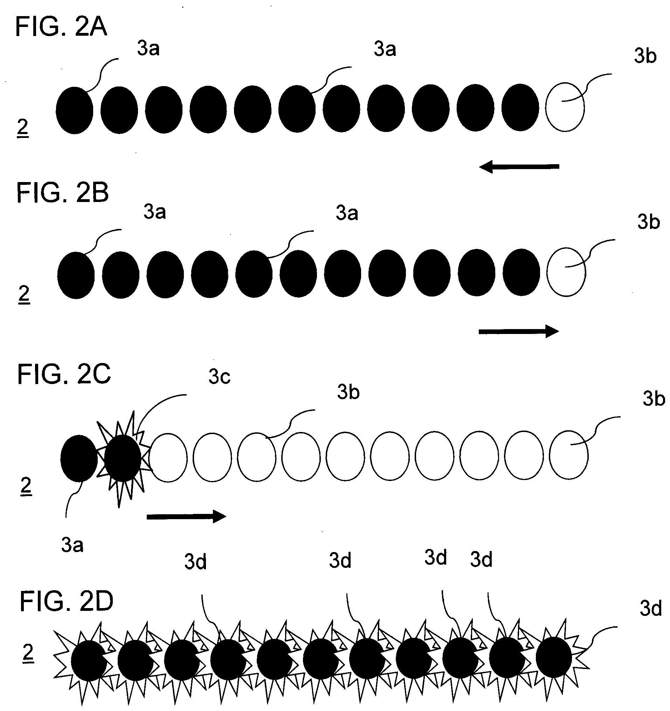

Die Anzeigevorrichtung 2 ist mit einer Ladezustandsmesseinheit der Batterie des Elektroantriebs verbunden (nicht gezeigt). Derartige SOC(state of charge)-Messeinheiten und Messverfahren zur SOC-Messung von Batterien sind aus dem Stand der Technik wohl bekannt und daher vorliegend nicht weiter ausgeführt. Abhängig von dem von der SOC-Messeinheit empfangenen Signal steuert die Anzeigevorrichtung 2 die Anzeige der Leuchtelemente 3, was nachfolgend in den Figuren 2A bis 2C erläutert ist.

Der Bereich der Leuchtelemente 3 gibt den nutzbaren Bereich laut Auslegung des Energiespeichers an. Mit anderen Worten nimmt die Anzahl der erleuchteten Anzeigeelemente 3 mit abnehmenden Ladezustand (SOC) des Energiespeichers ab und mit zunehmenden Ladezustand des Energiespeichers zu. Auf diese Weise kann ein vollständig geladener Energiespeicher durch gleichzeitiges Erleuchten aller Anzeigeelemente 3 dargestellt werden, und ein Teilladezustand durch Erleuchten nur eines Teils der Anzeigeelemente, wobei die Anzahl der erleuchteten Anzeigeelemente proportional zum Ladezustand des Energiespeichers ist.

Mit den Bezugszeichen 3a ist ein erleuchtetes Leuchtelement bezeichnet, mit dem Bezugszeichen 3b ein nicht-erleuchtetes. Im Fahrbetrieb nimmt mit zunehmendem Verbrauch des Energiespeichers die Anzahl der erleuchteten Punkte 3a ab, was durch den nach links gerichteten Pfeil in Figur 2A dargestellt ist. Ist das Fahrzeug in der Lage, Energie zu rekuperien, kann auch im Fahrbetrieb die Anzahl der erleuchteten Punkte 3a wieder zunehmen, was durch den nach rechts gerichteten Pfeil in Figur 2B dargestellt ist.

Die Anzeigevorrichtung 2 ist ferner eingerichtet, zu signalisieren, dass ein externer Ladevorgang, beispielsweise durch Induktion, Plug-in etc., im Gange ist. Hierzu blinkt der letzte erleuchtete Punkt 3c langsam, so dass der Fahrer sofort erkennt, dass aufgrund des blinkenden Punktes 3c keine Störung vorliegt. Ferner erkennt der Fahrer, ohne sich im Fahrzeug zu befinden, anhand der Anzahl der erleuchteten Leuchtelemente 3a wie weit der Ladevorgang fortgeschritten ist.

Die Anzeigevorrichtung 2 hat weiterhin die Funktion Störungen im Energiespeichersystem zu signalisieren. Hierzu blinkt die gesamte Punktleiste 3d schnell.

Obwohl die Erfindung unter Bezugnahme auf bestimmte Ausführungsbeispiele beschrieben worden ist, ist es für einen Fachmann ersichtlich, das verschiedene Änderungen ausgeführt werden können und Äquivalente als Ersatz verwendet werden können, ohne den Bereich der Erfindung zu verlassen. Zusätzlich können viele Modifikationen ausgeführt werden, um eine Anzeige eines bestimmten Betriebszustand des Energiespeichers oder eine bestimmte konstruktive Ausführung der Anzeigevorrichtung an die Lehre der Erfindung anzupassen, ohne den zugehörigen Bereich zu verlassen. Folglich soll die Erfindung nicht auf das offenbarte bestimmte Ausführungsbeispiel begrenzt sein, sondern die Erfindung soll alle Ausführungsbeispiele umfassen, die in den Bereich der beigefügten Patentansprüche fallen.

### Bezugszeichenliste

- 1: Omnibus
- 2: Anzeigevorrichtung
- 3: Leuchtelemente
- 3a: erleuchtetes Leuchtelement
- 3b: nicht-erleuchtetes Leuchtelement
- 3c: blinkendes Leuchtelement
- 3d: schnell blinkende Leuchtelemente
- 4: Seitenwand des Omnibus
- 5: Dachaufbau
- 6: seitlicher Abschnitt des Dachaufbaus

## Patentansprüche

1. Fahrzeug mit einem Elektroantrieb, wobei das Fahrzeug ein Omnibus (1) ist, mit einer Anzeigevorrichtung (2) zur Anzeige eines Betriebszustandes eines Energiespeichers des Elektroantriebs, wobei die Anzeigevorrichtung (2) an einer Fahrzeugaußenhaut angeordnet ist, derart, dass die Anzeige des Betriebszustandes von außerhalb des Fahrzeugs sichtbar ist; **dadurch gekennzeichnet,**
**dass** die Anzeigevorrichtung (2) an einem oberen seitlichen Dachabschnitt (6) des Omnibusses (1) angeordnet ist;
**dass** die Anzeigevorrichtung (2) eine Vielzahl von Anzeigeelementen (3) umfasst, die linear ausgerichtet angeordnet sind;
**dass** die Vielzahl von Anzeigeelementen (3) linear angeordnete LED Punktmatrizen oder OLED umfassen; und
**dass** die einzelnen Anzeigeelemente (3) einen Durchmesser von mindestens 10 cm aufweisen.

2. Fahrzeug nach Anspruch 1, **dadurch gekennzeichnet, dass** die Anzeigevorrichtung (2) außenseitig am Fahrzeug angeordnet ist.

3. Fahrzeug nach Anspruch 1 oder 2, **dadurch gekennzeichnet, dass** die Anzeigevorrichtung (2) in einem oberen Endbereich der Fahrzeugaußenhaut angeordnet ist.

4. Fahrzeug nach einem der vorhergehenden Ansprüche, **dadurch gekennzeichnet, dass** die Anzeigevorrichtung (2) eingerichtet ist, anzuzeigen, wenn der Energiespeicher von einer externen Energiequelle aufgeladen wird.

5. Fahrzeug nach einem der vorhergehenden Ansprüche, **dadurch gekennzeichnet, dass** der Omnibus (1) eine zweite Anzeigevorrichtung (2) zur Anzeige des Betriebszustandes des Energiespeichers des Elektroantriebs umfasst, die im Fahrzeuginneren angeordnet ist, derart, dass der von der zweiten Anzeigevorrichtung (2) angezeigte Betriebszustand für auf Fahrgastsitzen sitzende Fahrgäste sichtbar ist.

6. Fahrzeug nach einem der vorhergehenden Ansprüche, **dadurch gekennzeichnet, dass** die Anzahl der erleuchteten Anzeigelemente (3) mit abnehmenden Ladezustand des Energiespeichers abnimmt und mit zunehmenden Ladezustand des Energiespeichers zunimmt..

7. Fahrzeug nach einem der vorhergehenden Ansprüche, **dadurch gekennzeichnet, dass** die Anzeigevorrichtung (2) eingerichtet ist, einen Ladungszustand des Energiespeichers auch im Nichtfahrbetrieb des Fahrzeugs anzuzeigen.

8. Fahrzeug nach einem der vorhergehenden Ansprüche, **dadurch gekennzeichnet, dass** die Anzeigevorrichtung (2) eingerichtet ist, eine Fehlfunktion des Energiespeichers im Betrieb und auch im Nichtfahrbetrieb des Fahrzeugs anzuzeigen.

## Claims

1. Vehicle having an electric drive, wherein the vehicle is a bus (1), having a display device (2) for displaying an operating state of an energy store of the electric drive, wherein the display device (2) is arranged on the outer skin of a vehicle such that the display of the operating state can be viewed from outside the vehicle, **characterized**
**in that** the display device (2) is arranged on an upper lateral roof section (6) of the bus (1);
**in that** the display device (2) comprises a multiplicity of display elements (3) which are arranged aligned linearly;
**in that** the multiplicity of display elements (3) comprise linearly arranged LED dot matrices or OLED; and
**in that** the individual display elements (3) have a diameter of at least 10 cm.

2. Vehicle according to Claim 1, **characterized in that** the display device (2) is arranged on the outside of the vehicle.

3. Vehicle according to Claim 1 or 2, **characterized in that** the display device (2) is arranged in an upper end region of the outer skin of the vehicle.

4. Vehicle according to one of the preceding claims, **characterized in that** the display device (2) is configured to display if the energy store is charged by an external energy source.

5. Vehicle according to one of the preceding claims, **characterized in that** the bus (1) comprises a second display device (2) for displaying the operating state of the energy store of the electric drive, which display device (2) is arranged in the interior of the vehicle such that the operating state which is displayed by the second display device (2) can be seen by passengers sitting on passenger seats.

6. Vehicle according to one of the preceding claims, **characterized in that** the number of illuminated display elements (3) decreases as the state of charge of the energy store decreases and increases as the state of charge of the energy store increases.

7. Vehicle according to one of the preceding claims, **characterized in that** the display device (2) is configured to display a state of charge of the energy store even in the non-driving mode of the vehicle.

8. Vehicle according to one of the preceding claims, **characterized in that** the display device (2) is configured to display a malfunction of the energy store during operation and also in the non-driving mode of the vehicle.

## Revendications

1. Véhicule comprenant un groupe propulseur électrique, le véhicule étant un autobus (1), comprenant un dispositif d'affichage (2) destiné à afficher un état opérationnel d'un accumulateur d'énergie du groupe propulseur électrique, le dispositif d'affichage (2) étant disposé sur une enveloppe de véhicule de telle sorte que l'affichage de l'état opérationnel soit visible depuis l'extérieur du véhicule, **caractérisé en ce**
**que** le dispositif d'affichage (2) est disposé au niveau d'une portion de toit (6) latérale supérieure de l'autobus (1) ;
**que** le dispositif d'affichage (2) comporte une pluralité d'éléments d'affichage (3) qui sont disposés selon une orientation linéaire ;
**que** la pluralité d'éléments d'affichage (3) comporte des matrices à points LED ou des OLED disposées de façon linéaire ; et
**que** les éléments d'affichage (3) individuels présentent un diamètre d'au moins 10 cm.

2. Véhicule selon la revendication 1, **caractérisé en ce que** le dispositif d'affichage (2) est disposé du côté extérieur sur le véhicule.

3. Véhicule selon la revendication 1 ou 2, **caractérisé en ce que** le dispositif d'affichage (2) est disposé dans une zone d'extrémité supérieure de l'enveloppe du véhicule.

4. Véhicule selon l'une des revendications précédentes, **caractérisé en ce que** le dispositif d'affichage (2) est conçu pour afficher quand l'accumulateur d'énergie est chargé depuis une source d'énergie externe.

5. Véhicule selon l'une des revendications précédentes, **caractérisé en ce que** l'autobus (1) comporte un deuxième dispositif d'affichage (2) destiné à afficher l'état opérationnel de l'accumulateur d'énergie du groupe propulseur électrique, lequel est disposé à l'intérieur du véhicule de telle sorte que l'état opérationnel affiché par le deuxième dispositif d'affichage (2) soit visible pour les passagers assis sur les sièges de passager.

6. Véhicule selon l'une des revendications précédentes, **caractérisé en ce que** le nombre d'éléments d'affichage (3) allumés diminue à mesure que l'état de charge de l'accumulateur d'énergie diminue et augmente à mesure que l'état de charge de l'accumulateur d'énergie augmente.

7. Véhicule selon l'une des revendications précédentes, **caractérisé en ce que** le dispositif d'affichage (2) est conçu pour afficher un état de charge de l'accumulateur d'énergie même lorsque le véhicule n'est pas en régime de déplacement.

8. Véhicule selon l'une des revendications précédentes, **caractérisé en ce que** le dispositif d'affichage (2) est conçu pour afficher un défaut de fonctionnement de l'accumulateur d'énergie en fonctionnement et aussi lorsque le véhicule n'est pas en régime de déplacement.
